# EUROPÄISCHE PATENTANMELDUNG

(11) **EP 4 428 272 A1**
(43) Veröffentlichungstag der Anmeldung: **11.09.2024**
(21) Anmeldenummer: 23161156.7
(22) Anmeldetag: 10.03.2023
(51) Int. Cl.: C30B 15/14, C30B 15/20, C30B 29/06

(54) **VERFAHREN ZUM ZIEHEN EINES EINKRISTALLSTABS AUS HALBLEITERMATERIAL UND SCHEIBE AUS HALBLEITERMATERIAL**

(71) Anmelder: Siltronic AG, 81677 München (DE)
(72) Erfinder: Molchanov, Alexander, 84533 Marktl (DE); Zemke, Dirk, 5122 Ach (AT)
(74) Vertreter: Grundner, Sebastian

(57) **Zusammenfassung**

Verfahren zum Ziehen eines Einkristallstabs aus Halbleitermaterial aus einer Schmelze gemäß der Czochralski-Methode, umfassend die folgenden Schritte:
(i) Bereitstellen einer Schmelze und eines zylindrischen Impfkristalls aus Halbleitermaterial über der Schmelze, wobei die Zylinderachse des Impfkristalls entlang der Ziehrichtung ausgerichtet ist;
(ii) Absenken des Impfkristalls mit einer Geschwindigkeit von nicht mehr als 30 mm/min in eine erste Position, bis ein Kontakt zwischen der kreisförmigen Unterseite des Impfkristalls und der Oberfläche der Schmelze hergestellt ist;
(iii) Halten des Impfkristalls in der ersten Position für nicht weniger als 20 Sekunden;
(iv) Eintauchen eines Teils des Impfkristalls in die Schmelze durch Absenken des Impfkristalls aus der ersten Position in eine zweite Position, in der die axiale Länge des in die Schmelze eingetauchten Teils des Impfkristalls mindestens dem Durchmesser des Impfkristalls entspricht, wobei das Eintauchen mit einer Geschwindigkeit von nicht weniger als 3 mm/min und nicht mehr als 30 mm/min erfolgt;
(v) Halten des Impfkristalls in der zweiten Position, bis der eingetauchte Teil des Impfkristalls geschmolzen ist; und
(vi) Ziehen eines Einkristallstabs aus der Schmelze durch Anheben des Impfkristalls; wobei die Temperatur der Schmelze in jedem der Schritte (iii) bis (v) unabhängig voneinander nicht weniger als 2°C und nicht mehr als 10°C über der Temperatur der Schmelze zu Beginn des Schrittes (vi) liegt.

## Beschreibung

### Technisches Gebiet

Gegenstand der vorliegenden Erfindung ist ein Verfahren zum Ziehen eines Einkristallstabs aus Halbleitermaterial, ein Verfahren zur Herstellung von Scheiben aus Halbleitermaterial, und eine Scheibe aus Halbleitermaterial.

### Stand der Technik

Scheiben aus Halbleitermaterial werden in einer Vielzahl von Prozessschritten hergestellt, die das Ziehen eines Einkristallstabs aus einer Schmelze, das Zersägen des Kristalls in Scheiben, und die Oberflächenbearbeitung der Scheiben umfassen.

Monokristalline Halbleiterscheiben (auch Wafer genannt) sind die Grundlage der modernen Elektronik. Während der Herstellung von modernen Bauelementen auf besagten Halbleiterscheiben werden thermische Prozesse mit mittlerweile sehr komplexen Beschichtungsschritten durchgeführt.

Halbleiterscheiben, insbesondere Halbleiterscheiben aus monokristallinem Silizium, werden üblicherweise hergestellt, indem zuerst ein monokristalliner Stab mit Hilfe des Float-Zone Verfahrens (FZ) oder des Czochralski Verfahrens (CZ) gezogen wird. Die so produzierten Stäbe werden mittels dafür geeigneter Sägen wie Drahtsägen, Innenlochsägen oder Bandsägen zu Kristallstücken und schließlich zu Halbleiterscheiben verarbeitet. Nach weiteren mechanischen, chemo-mechanischen und/oder chemischen Schritten kann auf der polierten Scheibe optional eine epitaktische Schicht abgeschieden werden.

Das CZ-Verfahren wird gewöhnlich zur Züchtung von Siliziumeinkristallen verwendet, da mit diesem Verfahren Einkristalle mit großem Durchmesser hergestellt werden können und das Verfahren außerdem verhältnismäßig kostengünstig ist.

Das CZ-Verfahren erfolgt üblicherweise durch Eintauchen eines gewöhnlich als Impfling bezeichneten Impfkristalls in die Siliziumschmelze bei über 1410°C und anschließendes Anheben des Impfkristalls. im Rahmen der vorliegenden Erfindung werden die Begriffe Impfkristall und Impfling synonym gebraucht.

Wenn der Impfkristall in Kontakt mit der heißen Siliziumschmelze gebracht wird, können im Impfkristall thermische Spannungen auftreten, die zur Ausbildung von Versetzungen im Impfkristall führen, die sich über die gesamte Länge des Kristallstabs fortsetzen können.

Diese Versetzungen können in manchen Fällen durch die Ausbildung eines Dünnhalses aus dem Einkristall entfernt werden. Um einen auch als Dash-Neck bezeichneten Dünnhals auszubilden, wird der rotierende Impfkristall mit hoher Geschwindigkeit nach oben gezogen, um den Durchmesser des im Wesentlichen zylindrischen Dünnhalses auf 3 bis 6 mm zu verringern. Ausgehend von dem versetzungsfreien Dünnhals kann dann der Durchmesser des Einkristallstabs wieder erhöht werden und zunächst ein Anfangskonus und schließlich ein zylindrischer Abschnitt mit dem gewünschten Durchmesser gezogen werden. Dieses Verfahren wird auch als Dash-Methode oder Dash-Neck-Methode bezeichnet.

Die Dash-Neck-Methode ist im Allgemeinen gut geeignet, um Stufenversetzungen im zylindrischen Abschnitt des Einkristallstabs zu vermeiden. Hingegen sind Schraubenversetzungen auch mit der Dash-Neck-Methode nur schwer und oft auch gar nicht aus dem Kristall zu entfernen.

Außerdem beschreibt beispielsweise die EP 1 498 517 A1, dass bei einem Impfling mit der Kristallorientierung {110} Versetzungen im Zentrum des Impflings nicht mit der Dash-Neck-Methode entfernt werden können. Bei einem Impfling mit einer {110}-Kristallorientierung, wenn also die Ziehrichtung des Kristalls senkrecht zur Kristallebene mit einem Miller'schen Index von [110] verläuft, können beim Eintauchen des Impflings in die Schmelze Gleitversetzungen im Zentrum entstehen, die sich in axialer Richtung, also entlang der Ziehrichtung des Einkristallstabs, über die gesamte Länge des Stabs fortsetzen. Auch bei einer Kristallorientierung von {100} treten bei einem Teil der gezogenen Einkristallstäbe selbst dann Versetzungen auf, wenn die Dash-Neck-Methode angewandt wird.

Die EP 1 498 517 A1 beschreibt ein Verfahren zum Ziehen eines Einkristallstabs aus Silizium gemäß der Czochralski-Methode, in dem die Entstehung von Versetzungen im Impfkristall verhindert wird. Somit müssen keine Versetzungen entfernt werden und das Verfahren kommt deshalb ohne die Dash-Neck-Methode aus. In dem in der EP 1 498 517 A1 beschriebenen Verfahren wird ein Impfling mit einem nach unten spitz zulaufendem Ende direkt über der Schmelze platziert und aufgeheizt, bevor der Impfling in die Schmelze eingetaucht wird. Dabei wird drauf geachtet, dass während der Phase des Eintauchens des Impflings die Temperaturschwankungen an der Oberfläche der Schmelze auf ± 5°C begrenzt werden.

JP 9255490 A2 schlägt außerdem vor, bei der Herstellung von Bor-dotierten Siliziumeinkristallen einen Impfling und eine Schmelze mit gleicher Borkonzentration zu verwenden, und dadurch die Ausbildung von durch unterschiedliche Gitterkonstanten hervorgerufene Versetzungen zu verhindern.

JP 2982053 B2 beschreibt ein Verfahren zum Ziehen eines Einkristalls, das ebenfalls ohne die Dash-Neck-Methode auskommt. In diesem Verfahren wird der Impfling knapp über die Schmelze abgesenkt und dort erwärmt, danach ein Teil des Impflings (Impfkristalls) mit einer Rate von 0,05-2 mm/min in die Schmelze eingetaucht und anschließend der eingetauchte Teil des Impflings aufgeschmolzen. Dabei weist der eingetauchte Teil eine Länge in vertikaler Richtung auf, die mindestens dem Durchmesser des Impflings entspricht. Durch das Aufschmelzen wird unter anderem der Teil des Impfkristalls, der durch thermische Spannungen entstandene Versetzungen aufweist, geschmolzen. Der Teil des Impflings, der nach dem Aufschmelzen übrigbleibt, weist somit keine Defekte mehr auf.

Die oben beschriebenen Verfahren sind allesamt relativ aufwendig und ineffizient und damit nur eingeschränkt in der Industrieproduktion einsetzbar. Zudem sind diese Verfahren nur unzureichend dazu geeignet, einen Einkristallstab mit der Kristallorientierung {110}, der frei von Schraubenversetzungen ist, herzustellen.

### Technische Aufgabe der Erfindung und deren Lösung

Der vorliegenden Erfindung liegt die Aufgabe zugrunde, ein effizientes Verfahren zum Ziehen eines Einkristallstabs aus Halbleitermaterial ohne Versetzungen, insbesondere eines Einkristallstabs ohne Schraubenversetzungen, gemäß der Czochralski-Methode bereitzustellen. Insbesondere ist es Ziel der vorliegenden Erfindung, ein effizientes Verfahren bereitzustellen, dass dazu geeignet ist, einen versetzungsfreien Einkristallstab aus Halbleitermaterial mit der Kristallorientierung {100}, {110} oder {111} bereitzustellen.

Gelöst wird diese Aufgabe gemäß dem ersten Aspekt der vorliegenden Erfindung durch das erfindungsgemäße Verfahren zum Ziehen eines Einkristallstabs aus Halbleitermaterial aus einer Schmelze gemäß der Czochralski-Methode, umfassend die folgenden Schritte:
(i) Bereitstellen einer Schmelze und eines zylindrischen Impfkristalls aus Halbleitermaterial über der Schmelze, wobei die Zylinderachse des Impfkristalls entlang der Ziehrichtung ausgerichtet ist;
(ii) Absenken des Impfkristalls mit einer Geschwindigkeit von nicht mehr als 30 mm/min in eine erste Position, bis ein Kontakt zwischen der kreisförmigen Unterseite des Impfkristalls und der Oberfläche der Schmelze hergestellt ist;
(iii) Halten des Impfkristalls in der ersten Position für nicht weniger als 20 Sekunden;
(iv) Eintauchen eines Teils des Impfkristalls in die Schmelze durch Absenken des Impfkristalls aus der ersten Position in eine zweite Position, in der die axiale Länge des in die Schmelze eingetauchten Teils des Impfkristalls mindestens dem Durchmesser des Impfkristalls entspricht, wobei das Eintauchen mit einer Geschwindigkeit von nicht weniger als 3 mm/min und nicht mehr als 30 mm/min erfolgt;
(v) Halten des Impfkristalls in der zweiten Position, bis der eingetauchte Teil des Impfkristalls geschmolzen ist; und
(vi) Ziehen eines Einkristallstabs aus der Schmelze durch Anheben des Impfkristalls;
wobei die Temperatur der Schmelze in jedem der Schritte (iii) bis (v) unabhängig voneinander nicht weniger als 2°C und nicht mehr als 10°C über der Temperatur der Schmelze zu Beginn des Schrittes (vi) liegt.

Bevorzugte Ausführungsformen des erfindungsgemäßen Verfahrens gemäß dem ersten Aspekt sind Gegenstand der abhängigen Ansprüche.

Es wurde überraschend festgestellt, dass mit dem erfindungsgemäßen Verfahren ein Einkristallstab mit der Kristallorientierung {110} hergestellt werden kann, der frei von Versetzungen, insbesondere frei von Schraubenversetzungen, ist. Außerdem ist das erfindungsgemäße Verfahren aufgrund der überraschend hohen Geschwindigkeiten, mit denen der Impfkristall vor dem Beginn des Kristallziehens bewegt werden kann, besonders effizient und damit wirtschaftlich.

In einem zweiten Aspekt ist die vorliegende Erfindung auf ein Verfahren zur Herstellung von Scheiben aus Halbleitermaterial gerichtet. Dieses Verfahren umfasst die folgenden Schritte:
Ziehen eines Einkristallstabs aus Halbleitermaterial gemäß dem ersten Aspekt der vorliegenden Erfindung;
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben.

Ein dritter Aspekt der vorliegenden Erfindung betrifft eine Scheibe aus Halbleitermaterial, die dadurch gekennzeichnet ist, dass
das Halbleitermaterial im Wesentlichen aus einkristallinem Silizium besteht,
die Scheibe einen Durchmesser von 300 mm und eine Kristallorientierung von {110} hat, und
die Scheibe keine Versetzungen aufweist, wobei die Untersuchung der Scheibe auf Versetzungen gemäß der folgenden Methode erfolgt:
   Platzieren der glanzgeätzten Scheibe auf einem Rotationstisch in einem Transmissions-Dunkelfeld-Polariskop,
   Versetzten der Scheibe auf dem Rotationstisch in Rotation,
   Durchstrahlen der rotierenden Halbleiterscheibe auf dem Rotationstisch mit einem linear polarisierten Infrarot-Laserstrahl, während die Halbleiterscheibe kontinuierlich oder diskontinuierlich in radialer Richtung verschoben wird,
   Bestimmung der ortsabhängigen Depolarisation und Transmission, und
   Identifizierung der Stellen, an denen der Laserstrahl depolarisiert wird als Versetzungen.

Die Scheibe aus Halbleitermaterial gemäß dem dritten Aspekt der vorliegenden Erfindung kann durch das erfindungsgemäße Verfahren gemäß dem zweiten Aspekt hergestellt werden.

### Kurzbeschreibung der Figuren

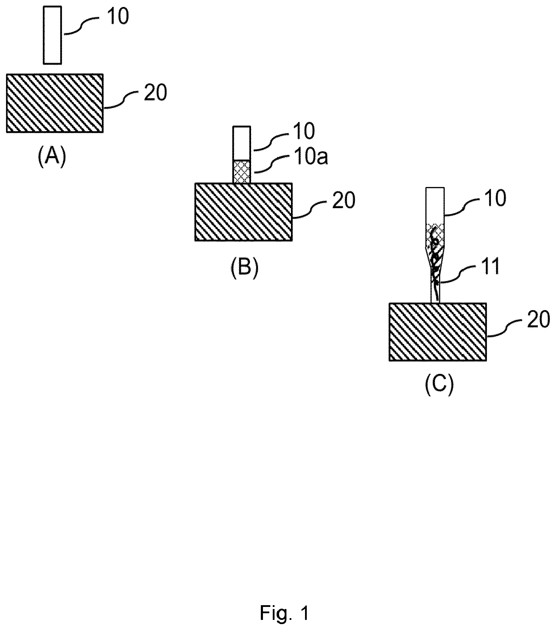

**Fig. 1** zeigt schematisch ein konventionelles Verfahren zum Ziehen eines Einkristallstabes gemäß der Czochralski-Methode durch Ziehen eines Impflings (10) aus einer Schmelze (20). Durch den thermischen Kontakt des Impfkristalls (10) mit der Schmelze (20) im Schritt (B) entstehen in einem unteren Teil (10a) des Impfkristalls (10) Versetzungen. Durch das Ziehen eines Dünnhalses (11) im Schritt (C) werden entstandene Schraubenversetzungen nicht entfernt und setzten sich entlang der Ziehrichtung fort.

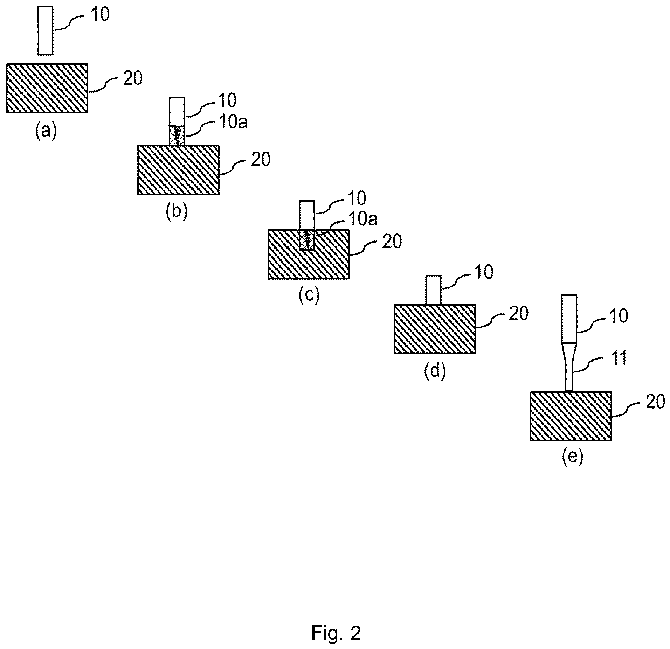

**Fig. 2** zeigt schematisch das erfindungsgemäße Verfahren, nämlich
   (a) das Bereitstellen einer Schmelze (20) und eines zylindrischen Impfkristalls (10) aus Halbleitermaterial über der Schmelze (20), wobei die Zylinderachse des Impfkristalls (10) entlang der Ziehrichtung ausgerichtet ist,
   (b) das Absenken des Impfkristalls (10) in eine erste Position, bis ein Kontakt zwischen Impfkristalls (10) und Schmelze (20) hergestellt ist und das Halten des Impfkristalls (10) in dieser Position,
   (c) das Eintauchen eines Teils (10a) des Impfkristalls (10) in die Schmelze (20) durch Absenken des Impfkristalls (10) aus der ersten Position in eine zweite Position,
   (d) das Halten des Impfkristalls (10) in der zweiten Position, bis der eingetauchte Teil des Impfkristalls geschmolzen ist, und
   (e) das Ziehen eines Einkristallstabs aus der Schmelze (20) durch Anheben des Impfkristalls (10), einschließlich des optionalen Ziehens eines Dünnhalses (11).

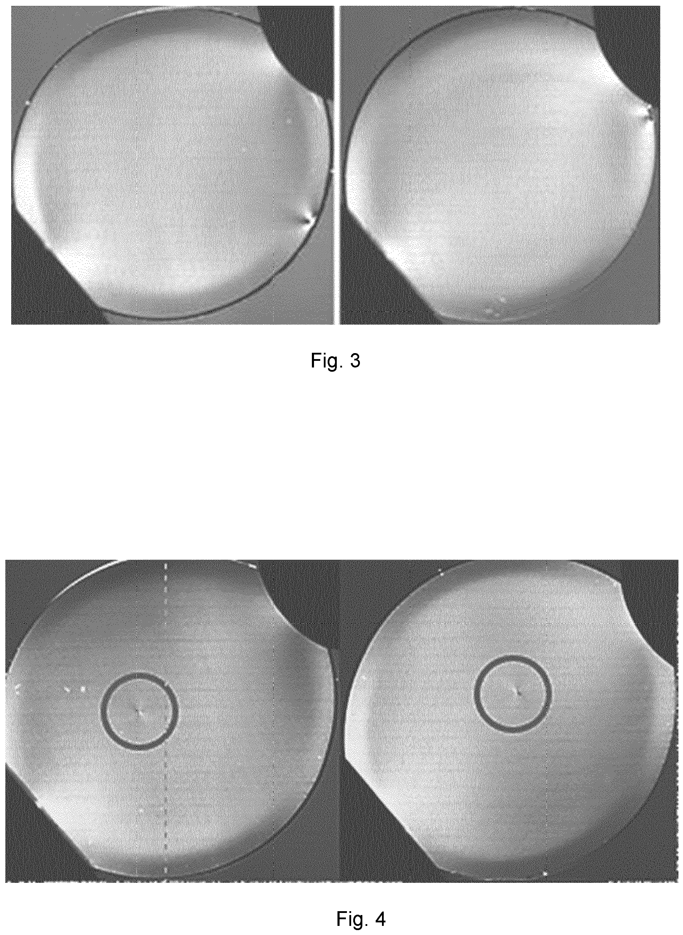

**Fig. 3** zeigt die mittels SIRD-Messungen ermittelten Depolarisationsverteilungen der im Ausführungsbeispiel hegestellten Scheiben und zeigt, dass diese Scheiben frei von Versetzungen waren.
**Fig. 4** zeigt die mittels SIRD-Messungen ermittelten Depolarisationsverteilungen der im Vergleichsbeispiel hegestellten Scheiben, die eine Versetzungen im Zentrum aufwiesen.

### Detaillierte Beschreibung der Erfindung

Eine Versetzung ist eine Störung der Periodizität eines Kristallgitters, die sich längs einer Linie im Kristall fortsetzt. Eine Schraubenversetzung ist eine Versetzung, die durch Drehung des Kristallgitters um die Versetzungslinie gekennzeichnet ist. Durch diese Torsion entsteht beim Umlauf um die Versetzungslinie herum ein Burgers-Vektor, der parallel zur Versetzungslinie liegt. Bei einem gemäß der Czochralski-Methode hergestellten Einkristallstab setzten sich mögliche Schraubenversetzungen entlang der Ziehrichtung fort. Insbesondere werden diese Schraubenversetzung im Zentrum des Querschnitts eines gemäß der Czochralski-Methode hergestellten Einkristallstabs beobachtet und daher auch als Zentrumsdefekt bezeichnet. Schraubenversetzungen treten oft paarweise auf und setzten sich im Zentrum des Einkristalls über die gesamte Länge eines Einkristallstabes fort. Wenn die Ziehrichtung nicht genau senkrecht zur Kristallfläche mit der gewünschten Orientierung, beispielsweise einer {100}-Kristallorientierung, einer {110}-Kristallorientierung oder einer {111 }-Kristallorientierung, verläuft, so liegt die Schraubenversetzung nicht genau im Zentrum, sondern entfernt sich mit zunehmenden Kristallwachstum vom Zentrum. So kann sich die Schraubenversetzung bei einem Kristallstab mit einem zylindrischen Abschnitt mit einem Durchmesser von 300 bis 330 mm und einer Länge von bis zu 3 m, bei einer Abweichung der Ziehrichtung von der senkrecht zur gewünschten Kristallorientierung verlaufenden Richtung von bis zu 5°, um bis zu 50 mm vom Zentrum des Kristalls entfernen. Da in der vorliegenden Erfindung die Abweichung der Ziehrichtung von der senkrecht zur gewünschten Kristallorientierung stehenden Achse bis zu 5° betragen kann, kann eine Schraubenversetzung im Sinne der vorliegenden Erfindung bei einem Einkristallstab mit einem Durchmesser von nicht weniger als 300 mm bis zu 50 mm vom Zentrum entfernt auftreten, wobei das Zentrum der Achse des geschliffenen Einkristallstabes entspricht. Somit entspricht das Zentrum auch dem Mittelpunkt der aus dem Stab geschnittenen Halbleiterscheiben.

Im erfindungsgemäßen Verfahren wird zunächst eine Schmelze und ein zylindrischer Impfkristalls aus Halbleitermaterial über der Schmelze bereitgestellt. Die Begriffe Impfkristall und Impfling werden synonym verwendet. Der Impfkristall ist zylindrisch und wird so über der Schmelze angeordnet, dass die Zylinderachse vertikal, also entlang der Ziehrichtung, ausgerichtet ist. Die Zylinderachse ist also parallel zur Ziehrichtung angeordnet. Die im folgenden angegebenen Geschwindigkeiten beziehen sich auf die Bewegung des Impfkristalls entlang der Zylinderachse. Vorzugsweise beträgt der Abstand des Impfkristalls von der Schmelze im Schritt (i) nicht weniger als 10 mm, mehr bevorzugt nicht weniger als 30 mm und besonders bevorzugt nicht wenige als 50 mm, wobei der Abstand zwischen dem Impfkristall und der Schmelze der Abstand der kreisförmigen Unterseite des Impfkristalls von der Oberfläche der Schmelze in vertikaler Richtung ist.

Der Impfkristall hat vorzugsweise einen Durchmesser von nicht weniger als 5 mm und nicht mehr als 25 mm. In einer besonders bevorzugten Ausführungsform hat der Impfkristall einen Durchmesser von nicht weniger als 10 mm und nicht mehr als 20 mm. Die axiale Länge des Impfkristalls entspricht mindestens dem dreifachen Durchmesser, vorzugsweise mindestens dem vierfachen Durchmesser, und am meisten bevorzugt mindestens dem fünffachen Durchmesser des Impfkristalls. Vorzugsweise entspricht die axiale Länge des Impfkristalls, die aus der Halterung des Impfkristalls nach unten herausragt mindestens dem dreifachen, besonders bevorzugt mindestens dem vierfachen Durchmesser des Impfkristalls (vor dem Eintauchen). Die Halterung ist dabei ein Element am unteren Ende der Ziehwelle oder des Seils, das zur Fixierung des oberen Teils des Impfkristalls an der Ziehwelle oder am Seil dient. Vorzugsweise bestehen die Schmelze und der Impfkristall im Wesentlichen aus Silizium. In einer bevorzugten Ausführungsform beträgt der Anteil von Silizium in der Schmelze und im Impfkristall jeweils nicht weniger als 99,0 Gew.-%, besonders bevorzugt jeweils nicht weniger als 99,8 Gew.-%, und am meisten bevorzugt jeweils nicht weniger als 99,9 Gew.-%. Die Schmelze und/oder der Impfkristall können dabei Dotierstoffe, beispielsweise des p-Typs und/oder des n-Typs, enthalten. Der Dotierstoff ist beispielsweise mindestens ein Element ausgewählt aus Bor, Aluminium, Gallium, Indium, Kohlenstoff, Germanium, Stickstoff, Phosphor, Arsen und Antimon. Dementsprechend ist der mit dem Verfahren gemäß dem ersten Aspekt der Erfindung hergestellte Einkristallstab vorzugsweise ein Stab aus einkristallinem Silizium und die mit dem Verfahren gemäß dem zweiten Aspekt der Erfindung hergestellte Scheibe vorzugsweise eine Scheibe aus einkristallinem Silizium, besonders bevorzugt aus einkristallinem Silizium, das aus nicht weniger als 99,8 Gew.-%, und am meisten bevorzugt aus nicht weniger als 99,9 Gew.-% Silizium besteht.

Die Schmelze, die vorzugsweise im Wesentlichen aus Silizium besteht, hat dabei eine Temperatur von nicht weniger 1410°C, vorzugsweise nicht weniger als 1420°C. Der Schmelzpunkt einer Siliziumschmelze liegt bei ca. 1410°C. In einer Ausführungsform ist die Schmelze zu Beginn des Verfahrens überhitzt. Dies bedeutet, dass die Temperatur der Schmelze höher als ihr Schmelzpunkt ist. So ist die Temperatur der Schmelze zu Beginn des erfindungsgemäßen Verfahrens, insbesondere vor dem Schritt (ii), vorzugsweise nicht weniger als 10°C über der Temperatur der Schmelze zu Beginn des Schrittes (vi), also der Temperatur der Schmelze zu Beginn des Ziehens eines Einkristallstabs aus der Schmelze durch Anheben des Impfkristalls. Die Temperatur der Schmelze zu Beginn des Schrittes (vi) wird im Folgenden auch als Temperatur der Schmelze bei Ziehbeginn bezeichnet.

Vorzugsweise ist die Temperatur der Schmelze zu Beginn des erfindungsgemäßen Verfahrens nicht weniger als 20° über der Temperatur der Schmelze bei Ziehbeginn. Besonders bevorzugt ist die Temperatur der Schmelze in den Schritten (i) bis (v) nicht mehr als 40°C über der Temperatur der Schmelze bei Ziehbeginn. In einer weiteren bevorzugten Ausführungsform ist die Temperatur der Schmelze während des gesamten erfindungsgemäßen Verfahrens nicht mehr als 50°C über dem Schmelzpunkt der Schmelze. Vorzugsweise befindet sich die Schmelze in einem Tiegel, um den herum eine oder mehrere Widerstandsheizungen angeordnet sind. In dieser Anordnung kann die Bereitstellung der Schmelze dadurch erfolgen, dass festes Halbleitermaterial in den leeren Tiegel gefüllt und anschließend erhitzt wird, wodurch das Halbleitermaterial unter Bildung der Schmelze geschmolzen wird. Das feste Halbleitermaterial ist vorzugsweise hochreines Polysilizium des Herstellers Wacker Chemie und der Tiegel vorzugsweise ein Quarztiegel.

Die Temperatur der Schmelze wird vorzugsweise an einem bestimmten Punkt an der Oberfläche der Schmelze gemessen, besonders bevorzugt mittels eines Pyrometers. In einer besonders bevorzugten Ausführungsform wird die Temperatur der Schmelze an einem Punkt an der Oberfläche der Schmelze gemessen, der nicht weiter als 100 mm vom Schnittpunkt der Schmelzoberfläche und der Ziehachse entfernt ist.

Der Impfkristall kann an einer Ziehwelle oder einem Seil befestigt werden, mittels derer er in vertikaler Richtung entlang der Ziehachse nach unten (zur Schmelze hin) oder nach oben (von der Schmelze weg) bewegt werden kann. Der Impfkristall besteht vorzugsweise aus einkristallinem Silizium, besonders bevorzugt mit einem Siliziumgehalt von nicht weniger als 99,9 Gew.-%. Die Zylinderachse des Impfkristalls wird entlang der Ziehrichtung ausgerichtet. Die Zylinderachse verläuft also in vertikaler Richtung. Der Impfkristall hat vorzugsweise eine {100}-Kristallorientierung, eine {110}-Kristallorientierung oder eine {111}-Kristallorientierung. Bei einer {100}-Kristallorientierung verläuft die Kristallebene mit einem Miller'schen Index von <100> senkrecht zur Zylinderachse des Impfkristalls und damit senkrecht zur Ziehrichtung. Entsprechend verläuft bei einem Impfkristall mit einer {110}-Kristallorientierung die Zylinderachse und die Ziehrichtung senkrecht zur die Kristallebene mit einem Miller'schen Index von <110>. Eine {100}-Kristallorientierung, eine {110}-Kristallorientierung oder eine {111}-Kristallorientierung im Sinne der vorliegenden Erfindung liegt vor, wenn die Abweichung der senkrecht zur Ziehrichtung verlaufenden Ebene von der Ebene mit der gewünschten Kristallorientierung nicht mehr als 5° beträgt. Dies bedeutet, dass eine senkrecht zur Kristallebene mit einer {100}-Kristallorientierung, einer {110}-Kristallorientierung, oder einer {111}-Kristallorientierung angeordnete Achse bis zu 5° von der Orientierung der Ziehachse, also der Ziehrichtung, abweichen kann. Vorzugsweise weicht die Ziehrichtung von der gewünschten Orientierung nicht mehr als 4° ab, besonders bevorzugt nicht mehr als 2°. Bei einer Scheibe bezieht sich die Kristallorientierung auf die Orientierung der Hauptfläche der Vorder- und/oder Rückseite der Scheibe.

Das erfindungsgemäße Verfahren kann zusätzlich einen Schritt des Vorwärmens des Impfkristalls über der Schmelze umfassen. Dieser Schritt findet vor dem Absenken des Impfkristalls in die erste Position statt. Der Schritt des Vorwärmens erfolgt, in dem der Impfkristall für einen Zeitraum von nicht weniger als 5 min in einem Abstand von nicht weniger als 5 mm und nicht mehr als 50 mm über der Schmelze gehalten wird. Der Abstand des Impfkristalls von der Schmelze ist dabei definiert als der Abstand der kreisförmigen Unterseite des zylindrischen Impfkristalls von der Oberfläche der Schmelze, vorzugsweise der Abstand des Kreismittelpunktes der kreisförmigen Unterseite des zylindrischen Impfkristalls von dem Punk der Oberfläche der Schmelze, der vertikal genau unterhalb des Kreismittelpunktes der kreisförmigen Unterseite liegt. Das Vorwärmen ermöglicht es, die Temperatur des Impfkristalls zu erhöhen, ohne dass thermische Spannungen und damit Versetzungen im Impfkristall entstehen. Durch die Einstellung eines Abstandes von 5 bis 50 mm kann die Zeit des Vorwärmens minimiert werden, wobei der Impfkristall mindestens 5 Minuten in diesem Abstand über der Schmelze gehalten werden soll.

In einer bevorzugten Ausführungsform erfolgt das Vorwärmen des Impfkristalls über der Schmelze für einen Zeitraum von nicht weniger als 10 min in einem Abstand der kreisförmigen Unterseite des Impfkristalls von der Oberfläche der Schmelze von nicht weniger als 10 mm und nicht mehr als 40 mm.

Während des Vorwärmens liegt die Temperatur der Schmelze vorzugsweise nicht weniger als 10°C über der Temperatur der Schmelze zu Beginn des Schrittes (vi), also der Temperatur der Schmelze bei Ziehbeginn. In einer weiteren bevorzugten Ausführungsform liegt die Temperatur der Schmelze während des Vorwärmens nicht weniger als 20°C und nicht mehr als 40°C über der Temperatur der Schmelze bei Ziehbeginn.

In einer besonders bevorzugten Ausführungsform erfolgt der Schritt des Vorwärmens für einen Zeitraum von nicht weniger als 20 min und nicht mehr als 40 min, in einem Abstand von nicht weniger als 20 mm und nicht mehr als 40 mm über der Schmelze, bei einer Temperatur der Schmelze, die nicht weniger als 20°C und nicht mehr als 40°C über der Temperatur der Schmelze bei Ziehbeginn (zu Beginn des Schrittes (vi)) liegt.

Das erfindungsgemäße Verfahren umfasst einen Schritt des Absenkens des Impfkristalls in eine erste Position, bis ein Kontakt zwischen der kreisförmigen Unterseite des Impfkristalls und der Oberfläche der Schmelze hergestellt ist (Schritt (ii)). In der ersten Position ist der Impfkristall vorzugsweise weniger als 2 mm, besonders bevorzugt weniger 1 mm und noch mehr bevorzugt weniger als 0,5 mm in die Schmelze eingetaucht. Am meisten bevorzugt ist der Impfkristall in der ersten Position weniger als 0,1 mm in die Schmelze eingetaucht. In der ersten Position besteht also ein Kontakt zwischen der kreisförmigen Unterseite des Impfkristalls und der Oberfläche der Schmelze. Der Kontakt im Sinne der vorliegenden Erfindung kann mindestens einer ausgewählt aus einer Berührung, einem thermischen Kontakt und einem elektrischen Kontakt zwischen der Unterseite des Impfkristalls und der Oberfläche der Schmelze sein.

Die Berührung kann beispielsweise visuell mit Hilfe einer Kamera beobachtet werden. So umfasst eine konventionelle Vorrichtung zum Ziehen eines Einkristalls mittels der Czochralski-Methode eine Ziehkammer, in der ein Tiegel zum Aufnehmen der Schmelze untergebracht ist, und ein Kamerasystem zum Beobachten einer Phasengrenze zwischen der Schmelze und dem Impfkristall, beziehungsweise der Schmelze und dem wachsenden Einkristall. Wenn eine Berührung von Schmelze und Impfkristall besteht, so liegt auch ein thermischer Kontakt vor.

Wenn ein thermischer Kontakt besteht, erfolgt eine direkte Wärmeleitung von der Oberfläche der Schmelze zur Unterseite des Impfkristalls. Dies bedeutet, dass Wärme direkt von der Oberfläche der Schmelze auf die Oberfläche Impfkristalls übertragen wird. Hingegen erfolgt die Wärmeübertragung bevor ein Kontakt zwischen der Unterseite des Impfkristalls und der Oberfläche der Schmelze hergestellt ist nur über Konvektion oder Wärmestrahlung. In der ersten Position erfolgt also eine direkte Wärmeleitung von der Oberfläche der Schmelze zur Oberfläche an der Unterseite des Impfkristalls. Es findet also eine direkte Übertragung von Wärme an der Grenzfläche von Schmelze und Impfkristall statt, die eine weitere Erhöhung der Temperatur des Impfkristalls ermöglicht. Dadurch kann die Temperatur des Impfkristalls weiter an die Temperatur der Schmelze angeglichen werden und so das Auftreten starker thermischer Spannungen beim weiteren Eintauchen des Impfkristalls verhindert werden.

Durch das Herstellen eines thermischen Kontakts vor dem weiteren Eintauchen des Impfkristalls in die Schmelze kann eine effiziente Angleichung der Temperatur des Impflings an die Temperatur der Schmelze erfolgen. Außerdem kann die Ausbildung und Ausbreitung von Versetzungen aufgrund der Vermeidung großer thermischer Spannungen verringert werden. Thermische Spannungen werden unter anderem dadurch verringert, dass der Impfkristall nicht, oder zumindest nicht mehr als 2 mm, in die Schmelze eingetaucht wird. Diese vorteilhafte Wirkung des erfindungsgemäßen Verfahrens wird auch dann beobachtet, wenn der Impfkristall in der ersten Position nicht mehr als 2 mm in die Schmelze eingetaucht ist. Wenn in der ersten Position einerseits ein thermischer Kontakt besteht und andererseits der Impfkristall weniger als 0,5 mm in die Schmelze eingetaucht ist, könne thermische Spannungen besonders effizient verhindert werden.

Über das Anlegen einer Spannung kann auch ein elektrischer Kontakt zwischen Impfling und Schmelze festgestellt werden.

Das Absenken des Impfkristalls in die erste Position während des Schrittes (ii) erfolgt mit einer Geschwindigkeit von nicht mehr als 30 mm/min, vorzugsweise mit einer Geschwindigkeit von nicht weniger als 5 mm/min und nicht mehr als 20 mm/min. Eine Absenkung des Impfkristalls mit dieser Geschwindigkeit ermöglicht es, das Auftreten von thermischen Spannungen im Impfkristall während des Absenkens zu verringern, und so die Ausbildung und Ausbreitung von Versetzungen zu reduzieren. Zudem kann mit dieser Absenkgeschwindigkeit der Schritt (ii) verhältnismäßig schnell durchgeführt und damit die Wirtschaftlichkeit des Verfahrens gewährleistet werden.

Im Anschluss an den Schritt (ii) erfolgt im Schritt (iii) das Halten des Impfkristalls in der ersten Position für einen Zeitraum von nicht weniger als 20 Sekunden, vorzugsweise für einen Zeitraum von nicht weniger als 60 Sekunden. Während des Haltens des Impfkristalls in der ersten Position liegt die Temperatur der Schmelze nicht weniger als 2°C und nicht mehr als 10°C über der Temperatur der Schmelze zu Beginn des Schrittes (vi), also der Temperatur der Schmelze bei Ziehbeginn. Wird der Impfkristall für weniger als 20 Sekunden in dieser Position gehalten, so wird nur eine unzureichende Angleichung der Temperatur von Schmelze und Impfling erreicht, so dass beim weiteren Eintauchen im Schritt (iv) größere thermische Spannungen und damit Versetzungen entstehen. Das Halten des Impfkristalls in der ersten Position für einen Zeitraum von nicht weniger als 30 Sekunden, vorzugsweise nicht weniger als 60 Sekunden, ermöglicht eine weitere Angleichung der Temperatur des Impflings and die Schmelztemperatur.

In einer besonders bevorzugten Ausführungsform erfolgt im Schritt (iii) das Halten des Impfkristalls in der ersten Position für einen Zeitraum von nicht weniger als 60 Sekunden bei einer Temperatur der Schmelze, die nicht weniger als 3°C und nicht mehr als 7°C über der Temperatur der Schmelze bei Ziehbeginn liegt. Diese Verfahrensbedingungen ermöglichen einen relativ schnellen und damit effizienten Angleich der Temperatur des Impfkristalls an die Temperatur der Schmelze, während gleichzeitig die Ausbildung und Ausdehnung von Versetzungen, insbesondere von Schraubenversetzungen im Zentrum des Impfkristalls, durch das Vermeiden großer thermischer Spannungen eingeschränkt wird. In einer besonders bevorzugten Ausführungsform wird der Impfkristall für nicht weniger als 60 Sekunden in der ersten Position gehalten, wobei die Temperatur der Schmelze während des Haltens in der ersten Position vorzugsweise nicht weniger als 3°C und nicht mehr als 5°C über der Temperatur der Schmelze bei Ziehbeginn liegt, wodurch die Ausbildung von Versetzungen noch weiter verringert werden kann.

Nach dem das Halten des Impfkristalls im Schritt (iii) abgeschlossen ist, erfolgt im Schritt (iv) das Eintauchen eines Teils des Impfkristalls in die Schmelze. Im Schritt (iv) wird der Impfkristall von der ersten Position weiter abgesenkt in eine zweite Position, in welcher ein Teil des Impfkristalls in die Schmelze eingetaucht ist. Das Eintauchen des Impfkristalls in die Schmelze erfolgt dabei mit einer Geschwindigkeit von nicht weniger als 3 mm/min und nicht mehr als 30 mm/min. Vorzugsweise erfolgt das Absenken im Schritt (iv) mit einer Geschwindigkeit von nicht weniger als 5 mm/min und nicht mehr als 15 mm/min. Während des Absenkens von der ersten in die zweite Position liegt die Temperatur der Schmelze nicht weniger als 2°C und nicht mehr als 10°C über der Temperatur der Schmelze bei Ziehbeginn, vorzugsweise nicht weniger als 3°C und nicht mehr als 7°C über der Temperatur der Schmelze bei Ziehbeginn. In einer besonders bevorzugten Ausführungsform erfolgt das Eintauchen des Impfkristalls in die Schmelze mit einer Geschwindigkeit von nicht weniger als 5 mm/min und nicht mehr als 20 mm/min bei einer Temperatur der Schmelze, die nicht weniger als 3°C und nicht mehr als 7°C über der Temperatur der Schmelze bei Ziehbeginn liegt.

In der zweiten Position entspricht die axiale Länge des in die Schmelze eingetauchten Teils des Impfkristalls mindestens dem Durchmesser des Impfkristalls. Vorzugsweise entspricht in der zweiten Position die axiale Länge des in die Schmelze eingetauchten Teils des Impfkristalls nicht weniger als dem 1,5-fachen Durchmesser des Impfkristalls. In einer anderen Ausführungsform entspricht in der zweiten Position die axiale Länge des in die Schmelze eingetauchten Teils des Impfkristalls nicht weniger als dem zweifachen Durchmesser des Impfkristalls. In einer besonders bevorzugten Ausführungsform entspricht die in die Schmelze eingetauchte axiale Länge des Impfkristalls nicht weniger als dem doppelten und nicht mehr als dem vierfachen Durchmesser des Impfkristalls. Demensprechend hat der Impfkristall (vor dem Eintauchen) vorzugsweise eine aus der Halterung des Impfkristalls nach unten herausragende axiale Länge, die mindestens dem dreifachen, besonders bevorzugt mindestens dem fünffachen, Durchmesser des Impfkristalls (vor dem Eintauchen) entspricht. Die Halterung ist dabei ein Element am unteren Ende der Ziehwelle oder des Seils und dient zur Fixierung des oberen Teils des Impfkristalls an der Ziehwelle oder am Seil.

Im Schritt (v) wird der Impfkristall in der zweiten Position gehalten, bis der eingetauchte Teil des Impfkristalls geschmolzen ist. Vorzugsweise wird der Impfkristall für nicht weniger als 5 min, besonders bevorzugt für nicht weniger als 10 min in der zweiten Position gehalten. Während des Haltens in der zweiten Position im Schritt (v) liegt die Temperatur der Schmelze nicht weniger als 2°C und nicht mehr als 10°C über der Temperatur der Schmelze bei Ziehbeginn. In einer besonders bevorzugten Ausführungsform ist die Temperatur der Schmelze im Schritt (v) nicht weniger als 3°C und nicht mehr als 7°C, am meisten bevorzugt nicht weniger als 4°C und nicht mehr als 5°C, über der Temperatur der Schmelze bei Ziehbeginn.

Diese Verfahrensbedingungen, insbesondere die Eintauchgeschwindigkeit im Schritt (iv) von nicht weniger als 3 mm/min und nicht mehr als 30 mm/min und die Temperatur der Schmelze in den Schritten (iii) bis (v) von nicht weniger als 2°C und nicht mehr als 10°C über der Temperatur der Schmelze bei Ziehbeginn ermöglichen dabei ein relativ schnelles und damit effizientes Rückschmelzen des Impfkristalles, wodurch die Ausbreitung von Versetzungen in den oberen, nicht eingetauchten Teil des Impfkristalles verhindert werden kann. Gleichzeitig wird durch diese Verfahrensbedingungen jedoch auch ein zu großer Temperaturgradient innerhalb des Impfkristalls während des Eintauchens und Rückschmelzens vermieden, wodurch thermische Spannungen verringert werden können. Dadurch kann ein Impfkristall ohne Versetzungen, insbesondere ohne Schraubenversetzungen, erhalten werden, indem das Rückschmelzen des Teils des Impfkristalls der Versetzungen aufweist rascher erfolgt als die Ausbreitung der Versetzungen, deren Entstehen weitgehend verhindert wird. Auch der optionale Schritt des Vorwärmens sowie die Schritte (i) bis (iii) tragen zu einem moderaten, möglichst schonenden Angleich der Temperatur des Impfkristalls an die Schmelztemperatur und somit zur Reduzierung der Generierung neuer Versetzungen im Impfkristall bei.

Nachdem der eingetauchte Teil des Impfkristalls im Schritt (v) geschmolzen ist, kann im Schritt (vi) des erfindungsgemäßen Verfahrens gemäß dem ersten Aspekt das Ziehen eines Einkristallstabs aus der Schmelze durch Anheben des Impfkristalls erfolgen. Wenn der eingetauchte Teil des Impfkristalls im Schritt (v) geschmolzen ist, bildet sich nämlich eine homogene Grenzschicht zwischen der Schmelze und dem festen Teil des Impfkristalls aus. Im Schritt (vi) wird dann die Ziehwelle oder das Seil, an welchen der Impfkristall befestigt ist, langsam unter Drehung nach oben gezogen, während die Schmelze an der sich ausbildenden Grenzfläche erstarrt. Durch Variation von Ziehgeschwindigkeit, Rotationsgeschwindigkeit und Temperatur erreicht der wachsende, rotierende Kristallstab den gewünschten Durchmesser. Mittels einer geeigneten Regelung kann der Durchmesser des Kristallstabs bis zum Ende des Ziehvorgangs sehr genau beibehalten werden.

Die Temperatur bei Ziehbeginn ist vorzugsweise nicht weniger als 1410°C, mehr bevorzugt nicht weniger als 1420°C und am meisten bevorzugt nicht weniger als 1425°C. Die Temperatur bei Ziehbeginn ist vorzugsweise nicht mehr als 1450°C, mehr bevorzugt nicht mehr als 1440°C, am meisten bevorzugt nicht mehr als 1435°C. In einer besonders bevorzugten Ausführungsform ist die Temperatur bei Ziehbeginn nicht weniger als 1420°C und nicht mehr als 1440°C.

Das erfindungsgemäße Verfahren kann im Schritt (vi) das Ziehen eines Dünnhalses gemäß der Dash-Neck-Methode beinhalten oder kann ohne das Ziehen eines Dünnhalses durchgeführt werden, bevor ein Anfangskonus und darauffolgend ein zylindrischer Abschnitt mit dem maximalen Durchmesser gezogen werden. Die Ziehgeschwindigkeit liegt vorzugsweise im Bereich von 1 bis 10 mm/min, besonders bevorzugt 2 bis 6 mm/min. Die Rotationsgeschwindigkeit des Kristalls liegt vorzugsweise im Bereich von 1 bis 20 Umdrehungen pro Minute, besonders bevorzugt 5 bis 15 Umdrehungen pro Minute.

Die Temperatur der Schmelze kann mit einer Messeinheit mit einer Genauigkeit von 0,1°C gemessen werden. Dabei wird vorzugsweise die Temperatur an der Oberfläche der Schmelze gemessen. Die Messeinheit zur Messung der Temperatur kann beispielsweise ein Pyrometer, eine Thermographiekamera, ein Thermoelement oder ein Dehnungsmesstreifen sein. Die Messeinheit zur Messung der Temperatur ist vorzugsweise ein Pyrometer. Die Temperatur der Schmelze an einem bestimmten Messpunkt kann mit einer Genauigkeit von 0,1°C gemessen und mit einer Genauigkeit von 1,0°C geregelt werden. Die Regelung der Temperatur der Schmelze kann über ein oder mehrere Heizelemente erfolgen, vorzugsweise eine oder mehrere Widerstandsheizungen, die um den Tiegel herum angeordnet sind. Die Heizelemente werden über eine programmierbare Steuereinheit gesteuert, die mit der Messeinheit verbunden ist und die Temperatur der Schmelze, insbesondere die Temperatur an der Oberfläche der Schmelze am Messpunkt, in Abhängigkeit von der gemessenen Temperatur mit einer Genauigkeit von 1,0°C regelt. Der Messpunkt ist ein Punkt auf der Oberfläche der Schmelze, der vorzugsweise nicht weniger als 50 mm und nicht mehr als 150 mm, besonders bevorzugt nicht weniger als 80 und nicht mehr als 120 mm, vom Schnittpunkt der Ziehachse und der Schmelzoberfläche entfernt ist, so dass mindestens bis zum Beginn des Ziehens des Anfangskonus die vom Messpunkt und dem Pyrometer gebildete Achse nicht vom Impfling unterbrochen wird und so eine genaue Temperaturbestimmung am Messpunkt mindestens bis zum Ziehbeginn möglich ist.

Gemäß dem zweiten Aspekt der vorliegenden Erfindung können Scheiben aus Halbleitermaterial hergestellt werden, indem im Anschluss an das Verfahren zum Ziehen eines Einkristallstabs gemäß dem ersten Aspekt die folgenden Schritte durchgeführt werden: Schleifen des Einkristallstabs; Sägen des geschliffenen Einkristallstabs in Scheiben; Schleifen und/oder Läppen der Scheiben; Polieren der Scheiben; und chemisches Reinigen der Scheiben. Nach dem Abschluss des Ziehens kann der Kristallstab also in dieser Reihenfolge in Stücke gesägt und geschliffen, in Scheiben gesägt, die Scheiben anschließend geschliffen oder geläppt, poliert, chemisch gereinigt und so Halbleiterscheiben erhalten werden.

Die polierten Scheiben können dann, beispielsweise mittels SIRD (Scanning InfraRed Depolarization), auf Versetzungen untersucht werden. Die SIRD-Messung erfolgt mittels eines Transmissions-Dunkelfeld-Polariskops, wobei der Effekt der spannungsinduzierten Doppelbrechung genutzt wird. Dieser Effekt beruht darauf, dass Versetzungen Spannungsfelder erzeugen. Wird ein Material Scherspannungen ausgesetzt, so wird sein Brechungsindex anisotrop und das Material doppelbrechend. Einfallendes linear polarisiertes Laserlicht wird somit in Transmission oder Reflexion durch die Probe depolarisiert. Folglich sind die erhaltenen Depolarisationsverteilungen als Scherspannungsverteilungen interpretierbar.

Bei einer SIRD-Messung durchstrahlt ein fest positionierter, linear polarisierter Laserstrahl die zu untersuchende Scheibe aus Halbleitermaterial, die für die Messung auf einem Rotationtisch platziert, rotiert und kontinuierlich in radialer Richtung verschoben wird. Ist die Kristallstruktur der Scheibe versetzungs- und spannungsfrei, ändert sich die Polarisation des Laserstahls nicht. Liegen aber Versetzungen vor, erfährt der Laserstrahl eine lokale Depolarisation, die durch spannungsinduzierte Doppelbrechung verursacht wird. Zur Untersuchung der mit Hilfe des erfindungsgemäßen Verfahrens hergestellten Halbleiterscheiben kann beispielsweise ein SIRD-Messgerät des Typs PSI des Herstellers Semilab oder ein Gerät des Herstellers PVA Metrology & Plasma Solutions verwendet werden. Die laterale Auflösung der SIRD-Messung liegt üblicherweise im Bereich von 50 bis 100 µm. Die Bestimmung der ortsabhängigen Depolarisation und Transmission in einer Scheibe gemäß dem dritten Aspekt der vorliegenden Erfindung erfolgt also mit einer lateralen Auflösung von mindestens 100 µm, vorzugsweise 50 µm.

Mittels dieser Messung kann eine gemäß dem zweiten Aspekt der vorliegenden Erfindung hergestellte Scheibe aus Halbleitermaterial, insbesondere eine Scheibe aus einkristallinem Silizium mit einem Durchmesser von nicht weniger als 300 mm und einer {110}-Kristallorientierung, auf Versetzungen untersucht und so festgestellt werden, ob die Scheibe frei von Versetzungen ist. Die Scheibe aus Halbleitermaterial gemäß dem dritten Aspekt der vorliegenden Erfindung kann durch das erfindungsgemäße Verfahren gemäß dem zweiten Aspekt hergestellt werden. Eine {110}-Kristallorientierung im Sinne des dritten Aspekts der vorliegenden Erfindung liegt dann vor, wenn die Ziehachse nicht mehr als 5° von der senkrecht auf die Kristalleben mit einer {110}-Kristallorientierung stehende Achse abweicht. Somit kann die Orientierung der Hauptfläche der Vorder- und Rückseite der Scheiben gemäß dem dritten Aspekt der vorliegenden Erfindung bis zu 5° von der Orientierung der Kristallebene mit dem Miller'schen Index [110] abweichen.

### Detaillierte Beschreibung von erfindungsgemäßen Ausführungsbeispielen und von Vergleichsbeispielen

Im Ausführungsbeispiel wurde ein zylindrischer Impfkristall aus einkristallinem Silizium mit einer {110}-Kristallorientierung, einem Durchmesser von 18 mm und einer Länge von 100 mm verwendet, um einen Kristallstab mit {1 10}-Orientierung gemäß der Czochralski-Methode zu ziehen. Der Impfkristall wurde an der Ziehwelle einer Kristallziehanlage befestigt. Ein mit festem, hochreinen Polysilizium des Herstellers Wacker Chemie gefüllter Quarztiegel wurde in der Kristallziehanlage zwischen einer Widerstandsheizung angeordnet. Nachdem Schließen, Spülen und Evakuieren der Kristallziehanlage wurde der Quarztiegel mit dem Silizium erhitzt und so eine Siliziumschmelze bereitgestellt. Die verwendete Kristallziehanlage umfasste außerdem ein Kamerasystem zum Beobachten einer Phasengrenze sowie ein Pyrometer zur Bestimmung der Temperatur der Schmelze. Die genaue Position des Impfkristalls relativ zur Schmelze kann somit mit dem Kamerasystem bestimmt werden.

In einem ersten Schritt wurde die Siliziumschmelze auf eine Temperatur erhitzt, die 20°C über der Temperatur bei Ziehbeginn lag, also auf 1448°C. Der Impfkristall wurde dann für 30 Minuten in einem Abstand von 30 mm über der überhitzten Schmelze gehalten, um den Impfkristall vorzuwärmen. Der Abstand bezieht sich dabei auf den Abstand, in vertikaler Richtung, der Oberfläche der Schmelze zur Unterseite des Impfkristalls.

Im nächsten Schritt wurde die Temperatur der Siliziumschmelze um 16°C auf 1432°C reduziert, sodass die Temperatur der Schmelze nur noch 4°C über der Temperatur bei Ziehbeginn lag. Der Impfkristall wurde dann mit einer Geschwindigkeit von 10 mm/min nach unten bewegt, bis die Unterseite des Impfkristalls gerade in thermischen Kontakt mit der Schmelze war. Dabei wurden weniger als 0,5 mm des Impfkristalls in die Schmelze eingetaucht. Der Impfkristall wurde in dieser Position und bei dieser Temperatur für 60 Sekunden gehalten.

Der Impfkristall wurde dann mit einer Geschwindigkeit von 10 mm/min weiter nach unten bewegt, bis ein Teil des Impflings mit einer Länge der Zylinderachse von 40 mm in die Schmelze eingetaucht war. Die Temperatur der Schmelze lag bei 1432°C und somit 4°C über der Temperatur bei Ziehbeginn. Der Impfkristall wurde für 10 Minuten in dieser Position gehalten, bis der gesamte eingetauchte Teil des Impfkristalls mit einer Länge der Zylinderachse von 40 mm zurückgeschmolzen war.

Dann wurde die Temperatur der Schmelze auf 1428°C (Temperatur bei Ziehbeginn) abgesenkt und der Impfkristall langsam unter Rotation nach oben bewegt und so ein Dünnhals mit einem Durchmesser von 5 mm, darauffolgend ein Anfangskonus mit zunehmenden Kristalldurchmesser und schließlich nach Erreichen eines Kristalldurchmessers von über 300 mm ein Abschnitt mit einem annähernd konstanten Durchmesser gemäß der Czochralski-Methode gezogen. Die Ziehgeschwindigkeit betrug zu diesem Zeitpunkt ca. 4 mm/min und die Rotationsgeschwindigkeit des Kristalls betrug 10 Umdrehungen pro Minute. Abschließend wurde ein Endkonus mit abnehmendem Durchmesser gezogen.

Die in diesem Ausführungsbeispiel angegebenen Temperaturen wurden mittels eines Pyrometers des Typs Impac ISQ6 des Hersteller LumaSense an einem bestimmten Messpunkt auf der Schmelzoberfläche gemessen. Der Messpunkt war ein Punkt auf der Oberfläche der Schmelze, der 100 mm vom Schnittpunkt der Ziehachse und der Schmelzoberfläche entfernt war, so dass, bis der wachsende Impfkristallstab die Hälfte des maximalen Durchmessers erreichte hatte, die vom Messpunkt und dem Pyrometer gebildete Achse nicht vom Impfling oder dem wachsenden Kristallstab unterbrochen wurde. So war eine genaue Temperaturbestimmung am Messpunkt möglich, bis der wachsende Impfkristallstab die Hälfte des maximalen Durchmessers erreichte.

Nach dem Abschluss des Ziehens des Kristallstabs wurde der fertige Kristallstab entnommen, geschliffen, in Scheiben gesägt, geschliffen oder geläppt, poliert und chemisch gereinigt beziehungsweise glanzgeätzt. Die Scheiben wurden dann mittels SIRD auf Spannungen untersucht. Für die Untersuchung der Scheiben auf Spannungen wurde eine Scheibe auf einem Rotationstisch eines SIRD-Messgerätes des Typs PSI des Herstellers Semilab platziert. Das SIRD-Messgerät war ein Transmissions-Dunkelfeld-Polariskop mit einem fest positionierten, linear polarisierten Infrarot-Laserstrahl und einem Rotationstisch. Die auf dem Rotationstisch rotierende Scheibe wurde während der Messung kontinuierlich in radialer Richtung verschoben, so dass die gesamte Oberfläche der Scheibe von dem fest positionierten, linear polarisierten Laserstrahl abgetastet wurde. Es konnte gezeigt werden, dass die Scheiben keine Spannungen, insbesondere keine Spannungen im Umkreis von 50 mm um den Scheibenmittelpunkt herum, aufwies. Fig. 3 zeigt mittels SIRD-Messungen ermittelte Depolarisationsverteilungen der im Ausführungsbeispiel hegestellten Scheiben und zeigt, dass diese Scheiben frei von Versetzungen waren. Es wurden also im Ausführungsbeispiel defektfrei Scheiben aus einkristallinem Silizium mit einer {110}-Kristallorientierung ohne Schraubenversetzungen hergestellt.

Das Vergleichsbeispiel unterschied sich lediglich dadurch vom Ausführungsbeispiel, dass die Schritte (iii) bis (v) des erfindungsgemäßen Verfahrens nicht durchgeführt wurden. Der im Vergleichsbeispiel erhaltene Einkristallstab wies Versetzungen im Zentrum auf. Fig. 4 zeigt die mittels SIRD-Messungen ermittelten Depolarisationsverteilungen von Scheiben aus einkristallinem Silizium mit einer {110}-Kristallorientierung, die aus dem im Vergleichsbeispiel erhaltenen Kristallstab hegestellt wurden. In Fig. 4 sind Versetzungen im Zentrum der Scheiben zu erkennen. Somit zeigt das Vergleichsbeispiel, dass konventionelle Verfahren zum Ziehen eines Einkristallstabs aus Halbleitermaterial aus einer Schmelze gemäß der Czochralski-Methode, auch wenn sie das Ziehen eines Dünnhalses beinhalten, zu Versetzungen im Zentrum des Einkristallstabes führen.

## Patentansprüche

1. Verfahren zum Ziehen eines Einkristallstabs aus Halbleitermaterial aus einer Schmelze gemäß der Czochralski-Methode, umfassend die folgenden Schritte:
(i) Bereitstellen einer Schmelze und eines zylindrischen Impfkristalls aus Halbleitermaterial über der Schmelze, wobei die Zylinderachse des Impfkristalls entlang der Ziehrichtung ausgerichtet ist;
(ii) Absenken des Impfkristalls mit einer Geschwindigkeit von nicht mehr als 30 mm/min in eine erste Position, bis ein Kontakt zwischen der kreisförmigen Unterseite des Impfkristalls und der Oberfläche der Schmelze hergestellt ist;
(iii) Halten des Impfkristalls in der ersten Position für nicht weniger als 20 Sekunden;
(iv) Eintauchen eines Teils des Impfkristalls in die Schmelze durch Absenken des Impfkristalls aus der ersten Position in eine zweite Position, in der die axiale Länge des in die Schmelze eingetauchten Teils des Impfkristalls mindestens dem Durchmesser des Impfkristalls entspricht, wobei das Eintauchen mit einer Geschwindigkeit von nicht weniger als 3 mm/min und nicht mehr als 30 mm/min erfolgt;
(v) Halten des Impfkristalls in der zweiten Position, bis der eingetauchte Teil des Impfkristalls geschmolzen ist; und
(vi) Ziehen eines Einkristallstabs aus der Schmelze durch Anheben des Impfkristalls;
wobei die Temperatur der Schmelze in jedem der Schritte (iii) bis (v) unabhängig voneinander nicht weniger als 2°C und nicht mehr als 10°C über der Temperatur der Schmelze zu Beginn des Schrittes (vi) liegt.

2. Verfahren zum Ziehen eines Einkristallstabs aus Halbleitermaterial gemäß dem Anspruch 1, **dadurch gekennzeichnet, dass** die Temperatur der Schmelze in jedem der Schritte (iii) bis (v) unabhängig voneinander nicht weniger als 3°C und nicht mehr als 7°C über der Temperatur der Schmelze zu Beginn des Schrittes (vi) liegt.

3. Verfahren zum Ziehen eines Einkristallstabs aus Halbleitermaterial gemäß dem Anspruch 1 oder 2, **dadurch gekennzeichnet, dass** das Verfahren zusätzlich einen Schritt zum Vorwärmen des Impfkristalls über der Schmelze umfasst, wobei
der Schritt zum Vorwärmen des Impfkristalls vor dem Schritt (ii) durchgeführt wird;
der Impfkristall während des Vorwärmens für einen Zeitraum von nicht weniger als 5 min in einem Abstand von nicht weniger als 5 mm und nicht mehr als 50 mm über der Schmelze gehalten wird; und
der Abstand zwischen dem Impfkristall und der Schmelze der Abstand der kreisförmigen Unterseite des Impfkristalls von der Oberfläche der Schmelze in vertikaler Richtung ist.

4. Verfahren zum Ziehen eines Einkristallstabs aus Halbleitermaterial gemäß dem Anspruch 3, **dadurch gekennzeichnet, dass** das Vorwärmen des Impfkristalls über der Schmelze für einen Zeitraum von nicht weniger als 10 min im Abstand von nicht weniger als 10 mm und nicht mehr als 40 mm über der Schmelze erfolgt.

5. Verfahren zum Ziehen eines Einkristallstabs aus Halbleitermaterial gemäß dem Anspruch 3 oder 4, **dadurch gekennzeichnet, dass** die Temperatur der Schmelze während des Vorwärmens nicht weniger als 10°C über der Temperatur der Schmelze zu Beginn des Schrittes (vi) liegt.

6. Verfahren zum Ziehen eines Einkristallstabs aus Halbleitermaterial gemäß dem Anspruch 5, **dadurch gekennzeichnet, dass** die Temperatur der Schmelze während des Vorwärmens nicht weniger als 20°C und nicht mehr als 40°C über der Temperatur der Schmelze zu Beginn des Schrittes (vi) liegt.

7. Verfahren zum Ziehen eines Einkristallstabs aus Halbleitermaterial gemäß einem der Ansprüche 1 bis 6, **dadurch gekennzeichnet, dass** das Absenken des Impfkristalls in die erste Position während des Schrittes (ii) mit einer Geschwindigkeit von nicht weniger als 5 mm/min und nicht mehr als 20 mm/min erfolgt.

8. Verfahren zum Ziehen eines Einkristallstabs aus Halbleitermaterial gemäß einem der Ansprüche 1 bis 7, **dadurch gekennzeichnet, dass** das Halten des Impfkristalls in der ersten Position während des Schrittes (iii) für einen Zeitraum von nicht weniger als 60 Sekunden erfolgt.

9. Verfahren zum Ziehen eines Einkristallstabs aus Halbleitermaterial gemäß einem der Ansprüche 1 bis 8, **dadurch gekennzeichnet, dass** das Eintauchen im Schritt (iv) mit einer Geschwindigkeit von nicht weniger als 5 mm/min und nicht mehr als 15 mm/min erfolgt.

10. Verfahren zum Ziehen eines Einkristallstabs aus Halbleitermaterial gemäß einem der Ansprüche 1 bis 9, **dadurch gekennzeichnet, dass** das Halten des Impfkristalls in der zweiten Position im Schritt (v) für nicht weniger als 5 min erfolgt.

11. Verfahren zum Ziehen eines Einkristallstabs aus Halbleitermaterial gemäß einem der Ansprüche 1 bis 10, **dadurch gekennzeichnet, dass**
der Impfkristall einen Durchmesser von nicht weniger als 5 mm und nicht mehr als 25 mm hat, und
in der zweiten Position die axiale Länge des in die Schmelze eingetauchten Teils des Impfkristalls nicht weniger als dem zweifachen und nicht mehr als dem vierfachen Durchmesser des Impfkristalls entspricht.

12. Verfahren zum Ziehen eines Einkristallstabs aus Halbleitermaterial gemäß einem der Ansprüche 1 bis 11, **dadurch gekennzeichnet, dass** die Schmelze, der Einkristall und das Halbleitermaterial im Wesentlichen aus Silizium bestehen.

13. Verfahren zum Ziehen eines Einkristallstabs aus Halbleitermaterial gemäß dem Anspruch 12, **dadurch gekennzeichnet, dass** der Impfkristall eine Kristallorientierung von {100}, eine Kristallorientierung von {110} oder eine Kristallorientierung von {111} aufweist.

14. Verfahren zur Herstellung von Scheiben aus Halbleitermaterial, umfassend die folgenden Schritte:
Ziehen eines Einkristallstabs aus Halbleitermaterial gemäß einem der Ansprüche 1 bis 13;
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben.

15. Scheibe aus Halbleitermaterial, **dadurch gekennzeichnet, dass**
das Halbleitermaterial im Wesentlichen aus einkristallinem Silizium besteht,
die Scheibe einen Durchmesser von 300 mm und eine Kristallorientierung von {110} hat, und
die Scheibe keine Versetzungen aufweist, wobei die Untersuchung der Scheibe auf Versetzungen gemäß der folgenden Methode erfolgt:
Platzieren der glanzgeätzten Scheibe auf einem Rotationstisch in einem Transmissions-Dunkelfeld-Polariskop,
Versetzten der Scheibe auf dem Rotationstisch in Rotation,
Durchstrahlen der rotierenden Halbleiterscheibe auf dem Rotationstisch mit einem linear polarisierten Infrarot-Laserstrahl, während die Halbleiterscheibe kontinuierlich oder diskontinuierlich in radialer Richtung verschoben wird,
Bestimmung der ortsabhängigen Depolarisation und Transmission, und
Identifizierung der Stellen, an denen der Laserstrahl depolarisiert wird als Versetzungen.
